(19) Europäisches Patentamt / European Patent Office / Office européen des brevets

(11) **EP 2 783 553 B1**

## (12) EUROPÄISCHE PATENTSCHRIFT

(45) Veröffentlichungstag und Bekanntmachung des Hinweises auf die Patenterteilung:
**25.01.2023   Patentblatt 2023/04**

(21) Anmeldenummer: **12798646.1**

(22) Anmeldetag: **22.11.2012**

(51) Internationale Patentklassifikation (IPC):
*H05B 47/10* $^{(2020.01)}$      *H05B 41/24* $^{(2006.01)}$
*H03L 7/00* $^{(2006.01)}$

(52) Gemeinsame Patentklassifikation (CPC):
**H05B 47/10; H03L 7/00; H05B 41/24; Y02B 20/00**

(86) Internationale Anmeldenummer:
**PCT/EP2012/073292**

(87) Internationale Veröffentlichungsnummer:
**WO 2013/076174 (30.05.2013 Gazette 2013/22)**

(54) **HF-SYSTEM FÜR EINE HOCHFREQUENZLAMPE**

RF-SYSTEM FOR HIGH-FREQUENCY LAMP

RF-SYSTEME POUR LAMPE A HAUTE FRÉQUENCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.11.2011   DE 102011055624**

(43) Veröffentlichungstag der Anmeldung:
**01.10.2014   Patentblatt 2014/40**

(60) Teilanmeldung:
**22216065.7**

(73) Patentinhaber: **MACOM Technology Solutions Holdings, Inc.**
**Newport Beach, CA 92660 (US)**

(72) Erfinder:
- **HEUERMANN, Holger**
  **52076 Aachen (DE)**
- **SADEGHFAM, Arash**
  **52070 Aachen (DE)**

(74) Vertreter: **Zech, Stefan Markus et al**
**Meissner Bolte Patentanwälte**
**Rechtsanwälte Partnerschaft mbB**
**Postfach 86 06 24**
**81633 München (DE)**

(56) Entgegenhaltungen:
**US-A1- 2002 079 845      US-A1- 2010 253 231**
**US-A1- 2010 283 389      US-B1- 6 313 587**

**Beschreibung**

Die Erfindung betrifft eine Hochfrequenz-Signaleinkopplungsvorrichtung gemäß dem Oberbegriff des Anspruchs 1, ein Hochfrequenz-System gemäß dem Oberbegriff des Anspruchs 13, sowie ein Verfahren zum Betrieb einer Hochfrequenz-Einrichtung gemäß dem Oberbegriff des Anspruchs 14.

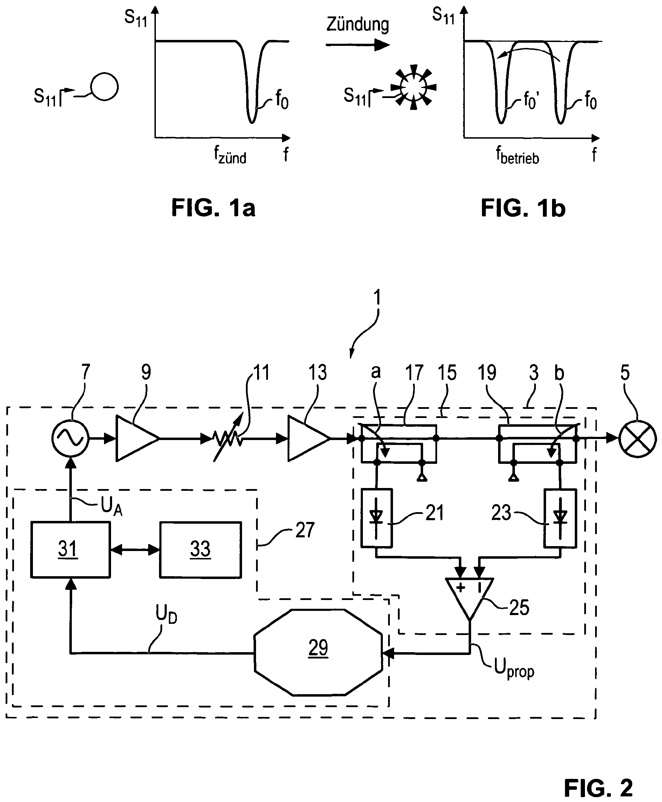

Ein HF-System der hier angesprochenen Art ist beispielsweise aus der WO 2009/068618 A2 bekannt. Es dient insbesondere zum effizienten Betrieb von Hochfrequenz-Einrichtungen wie Hochfrequenzlampen bei hohen Frequenzen, insbesondere im ISM-Band bei 2,45 GHz. Der Betrieb von HF-Einrichtungen, insbesondere HF-Lampen, HF-Zündkerzen oder dergleichen HF-Plasmaanwendungen setzt eine gute Hochfrequenzanpassung der Lampe voraus. Die Anpassung der Lampe ist frequenzabhängig und ein Maßstab dafür, welcher Anteil des durch einen Oszillator erzeugten HF-Signals zum Betrieb der Lampe von dieser aufgenommen werden kann. Je größer die Anpassung der HF-Einrichtung an die Frequenz eines zugeführten HF-Signals ist, desto geringer ist folglich der Anteil eines von der Lampe reflektierten Signals. Die Anpassung der HF-Einrichtung trägt damit wesentlich zur Gesamteffizienz des HF-Systems bei. Die Abweichung der Betriebsfrequenz von der optimalen angepassten Frequenz in einem HF-System in der Größenordnung von einigen 10 MHz können insbesondere bei hochfrequenzbetriebenen Energiesparlampen zu einer Verringerung der Effizienz von über 50% führen. Die Anpassung der HF-Einrichtung an ein zugeführtes HF-Signal ist von einigen Faktoren abhängig. Dabei handelt es sich insbesondere um Fertigungstoleranzen, das Temperaturverhalten und alterungsbedingte Änderungen der Elektronik der HF-Einrichtung. Darüber hinaus ändert sich die Lage und in der Regel auch der Betrag der Anpassung nach der Zündung der HF-Einrichtung, wie aus Fig. 1 deutlich wird. Fig. 1a zeigt eine schematische Darstellung der Betriebsfrequenz $f_0$ des der HF-Einrichtung zugeführten HF-Signals vor der Zündung und Fig. 1b zeigt dasselbe Signal nach der Zündung der HF-Einrichtung. Es wird deutlich, dass die Betriebsfrequenz $f_0'$ nach der Zündung der HF-Einrichtung verlagert ist, so dass diese nicht mehr der optimalen Betriebsfrequenz der HF-Einrichtung entspricht. Die Anpassung der HF-Einrichtung ist in diesem Fall nicht mehr optimal und es kommt zu Reflektionen eines der HF-Einrichtung zugeführten HF-Signals, was wie gesagt die Effizienz der HF-Einrichtung erheblich verringern kann.

Aus dem Stand der Technik sind Regelschaltungen bekannt, die zur dynamischen Regelung einer Anpassung einer HF-Einrichtung vorgesehen sind. Diese verwenden beispielsweise aus dem Bereich der Verstärkerentwicklung und MHz-Plasmatechnik bekannte veränderbare Kondensatoren. Dabei werden an Schrittmotoren angebundene Drehkondensatoren eingesetzt, um eine Impedanztransformation zu erzielen. Diese Lösung ermöglicht eine analoge Anpassung der HF-Einrichtung, sieht jedoch zwingend den Einsatz eines Mikrocontrollers vor, der die Regelung steuert und die einzelnen Einstellungen vornimmt. Dadurch wird zum einen die dynamische Anpassungszeit verlängert und die Schaltung wird darüber hinaus relativ aufwändig und kostenintensiv.

Darüber hinaus ist es bekannt, bei höheren Frequenzen, beispielsweise im Mobilfunkbereich, Schaltnetze vorzusehen, die durch Zu- bzw. Abschalten von unterschiedlichen induktiven und kapazitiven Elementen Anpassungswerke mit diskreten Zuständen zur dynamischen Anpassung einer Antenne ermöglichen. Durch diese Lösung können diskrete Anpasswerte für eine große Variante von Lastimpedanzen realisiert werden. Die realisierbaren diskreten Stufen und kompensierbaren Lastabweichungen sind abhängig von der Anzahl der Schaltzustände und den Elementen der Anpasswerke. Auch diese Lösung sieht zwingend den Einsatz eines Mikrocontrollers vor, was das gesamte System wiederum komplex und relativ teuer macht.

Die US 2002 / 079845 A1 beschreibt eine ultrahelle, induktiv gekoppelte, elektrodenlose Aperturlampe mit niedriger Leistung die von einer Festkörper-HF-Quelle im Bereich von einigen zehn bis mehreren hundert Watt bei verschiedenen Frequenzen im Bereich von 400 bis 900 MHz gespeist wird. Zahlreiche neuartige Lampenschaltungen und Komponenten werden vorgestellt, darunter eine trauringförmige Spule mit einer axialen und einer radialen Leitung, ein hochpräziser Kondensatorstapel, ein Aperturbecher mit hoher Wärmeleitfähigkeit und verschiedene andere Aperturlampenkonfigurationen, eine koaxiale Kondensatoranordnung und eine integrierte Spulen- und Kondensatorbaugruppe. Zahlreiche neue HF-Schaltungen werden ebenfalls offenbart, einschließlich einer Hochleistungs-Oszillatorschaltung mit einer Resonanzpolkonfiguration mit reduzierter Komplexität, parallelen HF-Leistungs-FET-Transistoren mit weicher Gate-Schaltung, einer Schaltung zur stufenlosen Frequenzabstimmung, einem Sechstor-Richtkoppler, einer impedanzschaltenden HF-Quelle und einer HF-Quelle mit kontrollierter Frequenzlastcharakteristik. Es werden zahlreiche neue HF-Steuerungsmethoden vorgestellt, darunter die kontrollierte Einstellung der Betriebsfrequenz, um eine Resonanzfrequenz zu finden und die reflektierte HF-Leistung zu reduzieren, das kontrollierte Schalten eines impedanzgeschalteten Lampensystems, die aktive Leistungssteuerung und die aktive Gate-Vorspannungssteuerung. Die vorgeschlagenen Lösungen werden als zu kompliziert und damit zu teuer zu realisieren empfunden.

Die US 2010/0253231 A1 beschreibt Systeme und Verfahren für eine elektrodenlose Plasmalampe. Eine Antriebssonde ist mit dem Lampenkörper gekoppelt, um die Primärleistung für die Zündung und den Dauerbetrieb der Lampe zu liefern. Die Rückkopplung wird verwendet, um die Frequenz als Reaktion auf sich ändernde Bedingungen der Lampe während des Starts anzupassen. Ein Phasenschieber wird verwendet, um die Phase der Leistung zwischen der Zündung und dem stationären Betrieb der Lampe einzustellen. Ein Sensor kann einen Lampenbetriebszustand erkennen, der automatisch eine Phasenverschiebung auslöst, nachdem die Füllung in der Lampe verdampft ist. Die Phasenverschiebung kann dann weiter angepasst werden, wenn sich das Plasma erwärmt und sich die Impedanz weiter ändert. Die Vorspannungsbedingungen eines Verstärkers können geändert werden, um die Betriebsklasse des Verstärkers für verschiedene Betriebsarten der Lampe zu ändern. Die vorgeschlagenen Lösungen werden als zu kompliziert und damit zu teuer zu realisieren empfunden.

Die US 2010/0283389 A1 beschreibt eine elektrostablose Koaxialwellenleiter-Lampe. Die Lampe ist in Analogie zu Koaxialhohlleiterkabeln ausgebildet, mit einem Außenleiter, einem zentralen Leiter und einem Gasfüllgefäß aus dielektrischem Material zwischen Außen- und Innenleiter. Das Gasfüllgefäß ist im Wesentlichen hohl und mit Substanzen gefüllt, die ein Plasma bilden und Licht aussenden, wenn die vom zentralen Leiter und vom Erdleiter getragene HF-Strahlung mit den Substanzen im Gasfüllgefäß wechselwirkt. Die vorliegende Erfindung bezieht sich auch auf eine elektrodenlose Lampe mit undichtem Wellenleiter. Die Lampe ist analog zu Leckwellenleitern aufgebaut, mit einem Leiter, einem Masseleiter und einem Gasfüllgefäß aus dielektrischem Material, das an den Leiter anstößt und vom Masseleiter umgeben ist. Die elektrodenlose Leckhohlleiterlampe emittiert Licht aus einem Plasma, das der oben beschriebenen Lichtemissionswirkung der elektrodenlosen Koaxialhohlleiterlampe ähnelt. Die vorgeschlagenen Lösungen werden als zu kompliziert und damit zu teuer zu realisieren empfunden.

Aufgabe der vorliegenden Erfindung ist es daher, eine HF-Signaleinkopplungsvorrichtung nach einem der Ansprüche 1-12 zu schaffen und ein HF-System nach Anspruch 13 umfassend eine HF-Einrichtung in Form einer HF-Lampe oder HF Zündkerze, welches die Anpassung der HF-Einrichtung an eine optimale Betriebsfrequenz einfach, kostengünstig und effizient realisiert.

Zur Lösung der oben beschriebenen Aufgabe wird eine Hochfrequenz-Signalkopplungsvorrichtung, eingerichtet zum Betrieb einer Hochfrequenz- Einrichtung, in Form einer Hochfrequenz-Lampe oder Hochfrequenz-Zündkerze nach Anspruch 1 vorgeschlagen, wobei die Hochfrequenz-Signaleinkopplungsvorrichtung einen Oszillator zur Erzeugung eines Hochfrequenz-Signals das der Hochfrequenz-Einrichtung zu ihrem Betrieb zugeführt wird aufweist, des weiteren Mittel aufweist, die zur Erzeugung eines zum Anpassungsgrad der Hochfrequenz-Einrichtung proportionalen Spannungssignals, auf der Grundlage des durch den Oszillator erzeugten und der Hochfrequenzeinrichtung zugeführten Hochfrequenz-Signals und eines von der Hochfrequenz-Einrichtung reflektierten Signals eingerichtet sind und des Weiteren eine Einrichtung zur Erzeugung eines Regelsignals zur Anpassung der Ausgangsfrequenz des Oszillators, auf der Grundlage des zum Anpassungsgrad der Hochfrequenz-Einrichtung proportionalen Spannungssignals, aufweist, wobei die Einrichtung eine Filtereinrichtung und einen Amplitudendiskriminator aufweist, wobei der Amplitudendiskriminator einen Komparator, eine Spannungswerterzeugungseinrichtung und eine Logikeinheit aufweist, wobei die Logikeinheit mindestens ein Logikgatter aufweist, wobei durch die Spannungswerterzeugungseinrichtung ein fester Spannungswert erzeugt wird, wobei das zum Anpassungsgrad der Hochfrequenz-Einrichtung proportionale Spannungssignal und der feste Spannungswert dem Komparator zugeführt werden, wodurch das proportionale Spannungssignal und der feste Spannungswert verglichen werden und eine erste Bedingung erzeugt wird, wobei der Amplitudendiskriminator dazu eingerichtet ist, auf der Grundlage des zum Anpassungsgrad der Hochfrequenz-Einrichtung proportionalen Spannungssignals eine zweite Bedingung zu erzeugen, wobei die erste Bedingung und die zweite Bedingung dem mindestens einen Logikgatter der Logikeinheit zugeführt werden, wobei der Amplitudendiskriminator weiter dazu ausgebildet ist, auf der Grundlage der ersten Bedingung, der zweiten Bedingung und einer Wahrheitstabelle, auf der das mindestens eine Logikgatter basiert, eine digitale oder getaktete Ausgangsspannung zu erzeugen und an die Filtereinrichtung auszugeben, wobei die Filtereinrichtung dazu ausgebildet ist, die digitale oder getaktete Ausgangsspannung derart zu glätten, dass ein analoges Ausgangssignal erzeugt wird, welches dem Oszillator als Regelsignal zur Anpassung der Ausgangsfrequenz ausgegeben wird.

Zur Lösung der oben genannten Aufgabe wird auch ein HF-System mit den Merkmalen des Anspruchs 13 vorgeschlagen. Das Hochfrequenz-System gemäß der Erfindung umfasst eine Hochfrequenz-Einrichtung, in Form einer Hochfrequenz- Lampe oder Hochfrequenz-Zündkerze, sowie eine Hochfrequenz- Signaleinkopplungsvorrichtung nach einem der Ansprüche 1-12.

Teile des Gegenstandes der Beschreibung, die nicht durch die Ansprüche abgedeckt sind, stellen Hintergrundinformation oder Beispiele dar, die für das Verständnis der Erfindung nützlich sind.

Ein wesentlicher Punkt der vorliegenden Erfindung liegt also darin, dass eine optimale Anpassung der HF-Einrichtung zum Zündungszeitpunkt und während des Betriebs gewährleistet wird, was durch eine Regelschaltung bewirkt wird, welche die Frequenz des Regelsignals auf die Frequenz der optimalen Anpassung der HF-Einrichtung dynamisch regelt. Eine solche Regelschaltung kann als ALL-Schaltung (Amplitude Locked Loop Schaltung) bezeichnet werden. Das erfindungsgemäße HF-System und insbesondere die erfindungsgemäße HF-Signaleinkopplungs-vorrichtung ermöglichen somit eine analoge und dynamische Regelung der Frequenzlage eines HF-Signals auf die Anpassung einer HF-Einrichtung, insbesondere einer Energiesparlampe, sowohl zum Zündungszeitpunkt als auch während des Betriebs der Energiesparlampe. Im Gegensatz zu den vorbekannten Lösungen des Standes der Technik benötigt die vorliegende Erfindung vorzugsweise keinen Mikrocontroller, sondern lediglich wenige Logikgatter, die eine für die Steuerung der Schaltungselemente notwendige Logikeinheit bilden. Das gesamte HF-System wird dadurch stark vereinfacht und kann bei Bedarf auf einem einzelnen Halbleiter-IC realisiert werden.

Der wesentliche Grundgedanke der vorliegenden Erfindung liegt darin, dass ein zum Anpassungsgrad der HF-Einrichtung proportionales Spannungssignal erzeugt wird bzw. entsprechende Mittel hierzu vorgesehen sind, wobei das zum Anpassungsgrad der HF-Einrichtung proportionale Spannungssignal auf der Grundlage des durch den Oszillator erzeugten HF-Signals und eines von der HF-Einrichtung reflektierten Signals erzeugt wird. Das zum Anpassungsgrad der HF-Einrichtung proportionale Spannungssignal wird dann in einer vorzugsweise mikroprozessorlosen Einrichtung, insbesondere unter Einsatz mindestens eines Logik-Gatters, derart weiter verarbeitet, dass ein Regelsignal zur Anpassung der Ausgangsfrequenz des Oszillators innerhalb kürzester Zeit ausgegeben werden kann.

Durch das erfindungsgemäße HF-System erfolgt eine analoge Regelung der Betriebsfrequenz auf die Frequenz mit der besten Anpassung der HF-Einrichtung. Dabei wird gewährleistet, dass die Zündung des HF-Plasmas bei einer optimalen Frequenz sicher erfolgt. Außerdem wird sichergestellt, dass der Betrieb der Lampe bei einer optimalen Frequenz erfolgt. Weiterhin wird sichergestellt, dass Abweichungen zwischen der Betriebsfrequenz und der optimalen Frequenz, die beispielsweise auf Fertigungstoleranzen, Temperaturverhalten oder alterungsbedingte Änderungen der Elektronik zurückzuführen sind, bei der Zündung und während des Betriebs berücksichtigt werden. Durch den Verzicht auf einen Mikrocontroller erzielt ein bevorzugtes HF-System gemäß der vorliegenden Erfindung eine schnellere Regelung der Betriebsfrequenz, da die Regelzeit nun im Wesentlichen lediglich eine Funktion von Gatterlaufzeiten ist. Darüber hinaus wird die gesamte Schaltungsanordnung der HF-Signaleinkopplungsvorrichtung kompakter, da nur einzelne Logikgatter benötigt werden. Die Schaltungsanordnung kann auch gegebenenfalls auf einem einzelnen Halbleiter-IC realisiert werden. Mit einem Halbleiter-IC entsteht ein kompakter und günstiger Lösungsansatz für eine Massenherstellung. Ein weiterer Vorteil, den die vorliegende Erfindung bietet, ist die wesentlich weniger aufwändige Entwicklung, da die Hardware schlanker ist und keine Software benötigt wird. Dadurch, dass keine Software benötigt wird, können im Übrigen auch keine Software-Bugs auftreten, so dass das HF-System insgesamt weniger störanfällig ist.

Besonders bevorzugt wird ein HF-System, bei dem die Mittel zur Erzeugung eines zum Anpassungsgrad der HF-Einrichtung proportionalen Spannungssignals mindestens eine Auskoppeleinrichtung zur Auskopplung eines Anteils des durch den Oszillator erzeugten HF-Signals sowie mindestens eine weitere Auskoppeleinrichtung zur Auskopplung eines Anteils des von der HF-Einrichtung reflektierten Signals aufweisen. Weiterhin ist vorzugsweise eine Spannungserfassungseinrichtung zur Erfassung und Ausgabe eines Spannungssignals des ausgekoppelten Anteils des durch den Oszillator erzeugten HF-Signals und mindestens eine weitere Spannungserfassungseinrichtung zur Erfassung und Ausgabe eines Spannungssignals des ausgekoppelten Anteils des von der HF-Einrichtung reflektierten Signals vorgesehen. Zur Erzeugung des eigentlichen zum Anpassungsgrad der HF-Einrichtung proportionalen Spannungssignals ist vorzugsweise eine Einrichtung, insbesondere mindestens ein Operationsverstärker vorgesehen, welcher auf der Grundlage des Spannungssignals des ausgekoppelten Anteils des von der HF-Einrichtung reflektierten Signals sowie des Spannungssignals des ausgekoppelten Anteils des durch den Oszillator erzeugten HF-Signals, das zum Anpassungsgrad der HF-Einrichtung proportionale Spannungssignal erzeugt.

Alternativ können die Mittel zur Erzeugung eines zum Anpassungsgrad der HF-Einrichtung proportionalen Spannungssignals einen Zirkulator aufweisen, der zur Auskopplung eines Anteils des durch den Oszillator erzeugten HF-Signals sowie zur Auskopplung eines Anteils des von der HF-Einrichtung reflektierten Signals ausgebildet ist und ggf. entsprechende Spannungssignale der ausgekoppelten Anteile erfasst und ausgibt. Vorzugsweise weist der Zirkulator mindestens eine Einrichtung auf, insbesondere mindestens einen Operationsverstärker oder mindestens eine Verstärkerschaltung, welche auf der Grundlage der Spannungssignale der ausgekoppelten Anteile ein zum Spannungsgrad der HF-Einrichtung proportionales Spannungssignal erzeugt.

Bei einem weiteren bevorzugten HF-System weist die vorzugsweise mikroprozessorlose Einrichtung zur Erzeugung eines Regelsignals zur Anpassung der Ausgangsfrequenz des Oszillators eine Logikeinheit mit mindestens einem, vorzugsweise zwei Logikgattern auf, die auf der Grundlage mindestens einer, vorzugsweise drei Bedingungen ein Regelsignal zur Anpassung der Ausgangsfrequenz des Oszillators ausgibt. Weiterhin kann die Logikeinheit mit einem Schieberegister verbunden sein, wobei das Schieberegister zum Empfang eines Ausgangssignals der Logikeinheit vorgesehen ist. Darüber hinaus kann die vorzugsweise mikroprozessorlose Einrichtung auch eine Taktgebereinrichtung aufweisen zur Taktung des Ausgangssignals der Logikeinheit. Auf diese Weise kann ein künstliches digitales Signal erzeugt bzw. getaktet werden. Vorzugsweise ist die Logikeinheit über einen Schleifenfilter zur Erzeugung einer analogen Ausgangsspannung zur Regelung des Oszillators mit diesem verbunden. Die analoge Ausgangsfrequenz wird insbesondere dadurch erzeugt, dass das digitale Ausgangssignal der Logikeinheit durch den Schleifenfilter geglättet wird. Alternativ kann statt dem Schleifenfilter eine Ladungspumpenanordnung (charge-pumps) vorgesehen sein zur Erzeugung einer analogen Ausgangsspannung, zur Regelung der Frequenz des Oszillators.

Als weitere Alternative kann sowohl auf den Schleifenfilter als auch auf die Ladungspumpenanordnung verzichtet werden und stattdessen die vorzugsweise mikroprozessorlose Einrichtung und insbesondere die Logikeinheit so ausgebildet sein, dass sie zur Erzeugung einer analogen Ausgangsspannung zur Regelung der Frequenz des Oszillators ausgebildet ist. Vorzugsweise weist das HF-System auch noch eine Reset-Schaltung auf, die zum Versetzen des Oszillators in einen vordefinierten Zustand ausgebildet ist. Durch die Reset-Schaltung ist es folglich möglich, einen vordefinierten Zustand des Oszillators, insbesondere eine vordefinierte Betriebsfrequenz einzustellen.

Schließlich wird zur Lösung der oben genannten Aufgabe auch noch ein Verfahren zum Betrieb eines erfindungsgemäßen Hochfrequenz-Systems, umfassend eine Hochfrequenz-Einrichtung, in Form einer Hochfrequenz-Lampe oder einer Hochfrequenz-Zündkerze vorgeschlagen, wobei das Verfahren den Schritt des Erzeugens eines festen Spannungswerts in einer Spannungswerterzeugungseinrichtung des Amplitudendiskriminators aufweist, des Weiteren den Schritt des Erzeugens einer ersten Bedingung, durch das dem Komparator Zuführen des zum Anpassungsgrad der Hochfrequenz-Einrichtung proportionalen Spannungssignals und des festen Spannungswerts und dem Vergleichen des proportionalen Spannungssignals und des festen Spannungswerts im Komparator aufweist, des Weiteren weist es den Schritt des Erzeugens einer zweiten Bedingung im Amplitudendiskriminator, auf der Grundlage des zum Anpassungsgrad der Hochfrequenz-Einrichtung proportionalen Spannungssignals, auf, des Weiteren weist es den Schritt des Zuführens der ersten Bedingung und der zweiten Bedingung, dem mindestens einen Logikgatter der Logikeinheit, auf, darüber hinaus weist es den Schritt des Erzeugens einer digitalen oder getakteten Ausgangsspannung im Amplitudendiskriminator, auf der Grundlage der ersten Bedingung, der zweiten Bedingung und einer Wahrheitstabelle, auf der das mindestens eine Logikgatter basiert, auf und weist den Schritt des Ausgebens der digitalen oder getakteten Ausgangsspannung an die Filtereinrichtung auf, des Weiteren weist es den Schritt des Erzeugens eines analogen Ausgangssignals durch Glätten der digitalen oder getakteten Ausgangsspannung durch die Filtereinrichtung auf und weist den Schritt des Ausgebens des analogen Ausgangssignals an den Oszillator als Regelsignal zur Anpassung der Ausgangsfrequenz des Oszillators auf.

Bevorzugt wird ein Verfahren, bei dem eine erste Bedingung auf der Grundlage des zum Anpassungsgrad der HF-Einrichtung proportionalen Spannungssignals vor der Erzeugung eines Regelsignals zur Anpassung der Ausgangsfrequenz des Oszillators erzeugt. Diese erste Bedingung wird vorzugsweise durch Vergleichen des zum Anpassungsgrad der HF-Einrichtung proportionalen Spannungssignals mit einem vordefinierten Spannungswert erhalten. Vorzugsweise wird noch eine zweite Bedingung auf der Grundlage des zum Anpassungsgrad der HF-Einrichtung proportionalen Spannungssignals vor der Erzeugung eines Regelsignals zur Anpassung der Ausgangsfrequenz des Oszillators erzeugt. Insbesondere wird dabei die zweite Bedingung durch Ableiten des zum Anpassungsgrad der HF-Einrichtung proportionalen Spannungssignals erhalten. Das erfindungsgemäße Verfahren umfasst vorzugsweise noch den Schritt des Zuführens der ersten und der zweiten Bedingung und insbesondere noch einer dritten Bedingung an ein oder mehrere Logikgatter sowie das Erzeugen eines Regelsignals zur Anpassung der Ausgangsfrequenz des Oszillators auf der Grundlage einer auf dem bzw. den Logikgattern basierend Wahrheitstabelle.

Hinsichtlich der Vorteile des erfindungsgemäßen Verfahrens wird auf die oben erläuterten Vorteile des erfindungsgemäßen HF-Systems verwiesen.

Die Erfindung wird im Folgenden anhand der Zeichnung näher erläutert. Es zeigen:

Fig. 1a    ein schematisches Schaubild der Betriebsfrequenz vor der Zündung der HF-Einrichtung;

Fig. 1b    ein schematisches Schaubild der Betriebsfrequenz nach der Zündung der HF-Einrichtung;

Fig. 2    ein schematisches Schaltbild eines Ausführungsbeispiels eines HF-Systems gemäß der Erfindung;

Fig. 3    ein schematisches Schaltbild eines Ausführungsbeispiels einer vorzugsweise mikroprozessorlosen Einrichtung zur Erzeugung eines Regelsignals zur Anpassung der Ausgangsfrequenz des Oszillators;

Fig. 4    eine schematische Darstellung eines Ausführungsbeispiels einer Logikeinheit gemäß der Erfindung;

Fig. 5    eine durch die Logikeinheit realisierte Wahrheitstabelle;

Fig. 6    eine schematische Darstellung eines Ausführungsbeispiels einer Taktgebereinrichtung;

Fig. 7    eine schematische Darstellung eines Ausführungsbeispiels eines Schleifenfilters, und

Fig. 8    eine schematische Darstellung eines Ausführungsbeispiels einer Reset-Schaltung.

Fig. 2 zeigt eine schematische Darstellung einer Ausführungsform eines HF-Systems 1 gemäß der Erfindung. Das HF-System 1 umfasst eine HF-Signaleinkopplungsvorrichtung 3 sowie eine HF-Einrichtung 5, bei der es sich um eine HF-Lampe, eine HF-Zündkerze oder dergleichen HF-Plasmaanwendung handeln kann. Im Folgenden wird die Erfindung rein beispielhaft anhand einer HF-Lampe unter Verwendung des Bezugszeichens 5 beschrieben.

Die HF-Signaleinkopplungsvorrichtung 3 dient zum Betrieb der HF-Lampe 5 und erzeugt hierzu ein HF-Signal mit einer Betriebsfrequenz für die Zündung und den Betrieb der HF-Lampe 5 mittels eines Oszillators 7. Bei der in Fig. 2 gezeigten Ausführungsform des HF-Systems 1 gemäß der Erfindung ist an den Oszillator 7 ein Verstärker 9 sowie ein Dämpfungsglied 11 angeschlossen, mittels der das Ausgangssignal des Oszillators 7 erhöht oder reduziert werden kann, bevor es über einen weiteren Verstärker 13 auf die Betriebsleistung erhöht wird. Die Verstärker 9 und 13 sowie das Dämpfungsglied 11 sind optional und können entweder weggelassen werden oder durch andere geeignete Elemente ersetzt werden. Denkbar ist auch die Anordnung in anderen Kombinationen zwischen der HF-Lampe 5 und dem Oszillator 7.

Die HF-Signaleinkopplungsvorrichtung 3 weist außerdem mit dem Bezugszeichen 15 zusammengefasste Mittel zur Erzeugung eines zum Anpassungsgrad der HF-Einrichtung proportionalen Spannungssignals auf. Gemäß der in der Fig. 2 dargestellten Ausführungsform der Erfindung umfassen diese Mittel 15 zwei Auskoppeleinrichtungen 17 und 19, wobei die Auskoppeleinrichtung 17 zur Auskopplung eines Anteils a des durch den Oszillator 7 erzeugten HF-Signals dient, während die Auskoppeleinrichtung 19 zum Auskoppeln eines Anteils b des von der HF-Lampe 5 reflektierten Signals dient. Es versteht sich, dass ein Signal b von der HF-Lampe 5 nur dann reflektiert wird, wenn die Lampe nicht optimal an die Frequenz des durch den Oszillator 7 erzeugten HF-Signals angepasst ist. Die Auskoppeleinrichtung 17 dient also zur Auskopplung einer HF-Lampe 5 hinlaufenden Leistung, während die Auskoppeleinrichtung 19 zur Auskopplung einer von der HF-Lampe 5 weglaufenden, d.h. reflektierten Leistung dient.

Die Mittel mit der Bezugsziffer 15 weisen darüber hinaus eine Spannungserfassungseinrichtung 21 (Detektor) auf, welche zur Erfassung und Ausgabe eines Spannungssignals des ausgekoppelten Anteils a des durch den Oszillator 13 erzeugten HF-Signals dient. Darüber hinaus ist eine Spannungserfassungseinrichtung 23 (Detektor) vorgesehen, die zur Erfassung und Ausgabe eines Spannungssignals des ausgekoppelten Anteils des von der HF-Lampe 5 reflektierten Signals b dient. Die beiden durch die Spannungserfassungseinrichtungen 21 und 23 erzeugten Spannungssignale werden gemäß der vorliegenden Ausführungsform der Erfindung einem gemeinsamen Operationsverstärker 25 zugeführt, der basierend auf den Ausgangsspannungen der Spannungserfassungseinrichtungen 21 und 23 eine zur Lampenanpassung proportionale Spannung $U_{prop}$ erzeugt.

Alternativ zu der Ausführungsform der mit der Bezugsziffer 15 gekennzeichneten Mittel zur Erzeugung eines zum Anpassungsgrad der HF-Lampe proportionalen Spannungssignals $U_{prop}$, kann statt der Auskoppeleinrichtungen 17 und 19 ein Zirkulator zum Einsatz kommen, der das reflektierte Signal der HF-Lampe 5 aus der Verbindung zwischen der HF-Lampe 5 und dem Oszillator 7 auskoppelt und als Regelgröße zur Verfügung stellt. Allerdings geht hierbei das HF-Signal des Oszillators 7 verloren. In diesem Fall kann entweder auf den Operationsverstärker 25 verzichtet werden, oder dieser kann durch eine Verstärkerschaltung ersetzt werden. Bei einer weiteren Ausführungsform der Mittel 15 zur Erzeugung eines zum Anpassungsgrad der HF-Lampe proportionalen Spannungssignals kann auch vorgesehen sein, lediglich eine Auskoppeleinrichtung 17 oder 19 vorzusehen, die jeweils zur Auskopplung sowohl des Anteils des durch den Oszillator 7 erzeugten HF-Signals sowie des von der Lampe 5 reflektierten HF-Signalanteils dienen kann.

Entscheidend ist lediglich, dass eine Einrichtung vorgesehen ist, welche aus dem HF-Signal des Oszillators 7 und des an der Lampe 5 reflektierten Signals ein zum Anpassungsgrad der HF-Einrichtung proportionales Spannungssignal erzeugt. Das heißt, das erzeugte, zum Anpassungsgrad der HF-Einrichtung proportionale Spannungssignal ist ein Maß dafür, wie viel des zur HF-Lampe 5 geführten HF-Signals des Oszillators 7 an der HF-Lampe 5 reflektiert wird und wie hoch folglich die Fehlanpassung der HF-Lampe ist.

In einem nachfolgenden Schritt wird gemäß der Erfindung die zur Lampenanpassung proportionale Spannung $U_{prop}$ einer vorzugsweise mikroprozessorlosen Einrichtung 27 zur Erzeugung eines Regelsignals zur Anpassung der Ausgangsfrequenz des Oszillators 7 zugeführt. Die vorzugsweise mikroprozessorlose Einrichtung 27 umfasst bei der in Fig. 2 gezeigten Ausführungsform einen Amplitudendiskriminator 29, eine Filtereinrichtung 31 sowie eine Reset-Schaltung 33. Der Amplitudendiskriminator 29 erzeugt auf der Grundlage der zum Anpassungsgrad der HF-Lampe 5 proportionalen Spannung $U_{prop}$ eine digitale bzw. getaktete Ausgangsspannung $U_D$, die wiederum einer Filtereinrichtung, insbesondere dem Schleifenfilter 31 zugeführt wird, der das getaktete Signal $U_D$ derart glättet, dass ein im Wesentlichen analoges Ausgangssignal $U_A$ erzeugt wird, welches dem Oszillator 7 als Regelspannung zugeführt wird. Die dem Oszillator 7 zugeführte Regelspannung $U_A$ ist folglich ein Maß dafür, ob die Frequenz des Oszillators 7 erhöht, erniedrigt oder gleich bleiben soll.

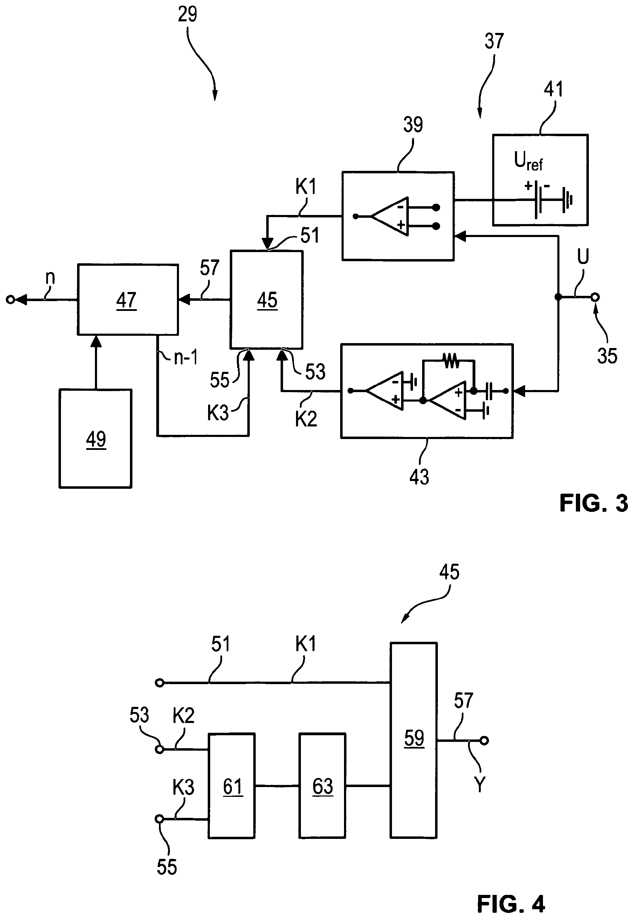

Fig. 3 zeigt eine beispielhafte Ausführungsform des in Fig. 2 dargestellten sogenannten Amplitudendiskriminators 29. Der Amplitudendiskriminator 29 weist einen Eingang 35 auf, an dem die zum Anpassungsgrad der HF-Lampe 5 proportionale Spannung $U_{prop}$ zugeführt wird. In dem Amplitudendiskriminator 29 werden bei dem vorliegenden Ausführungsbeispiel insgesamt drei Bedingungen K1, K2 und K3 erzeugt. Die erste Bedingung K1 wird auf der Grundlage des zum Anpassungsgrad der HF-Lampe 5 proportionalen Spannungssignals $U_{prop}$ erzeugt, indem es mit einem vordefinierten Spannungswert verglichen wird. Hierzu weist der Amplitudendiskriminator 29 einen Komparator 39 auf, dem einerseits das Spannungssignal $U_{prop}$ und andererseits ein fester Spannungswert zugeführt wird, der durch eine Spannungswerterzeugungseinrichtung 41 erzeugt wird. Die Spannungswerterzeugungseinrichtung 41 wird vorzugsweise durch einen Spannungsteiler realisiert. Der Komparator 39 vergleicht den aktuellen Wert der Spannung $U_{prop}$ mit dem festen Spannungswert der Spannungswerterzeugungseinrichtung 41. Das resultierende Ausgangssignal des Komparators 39 entspricht der ersten Bedingung K1.

Gleichzeitig wird in dem Amplitudendiskriminator 29 das Spannungssignal $U_{prop}$ einer Differenzierer-Einheit 43 mit integriertem invertiertem Komparator zugeführt, welche das Spannungssignal $U_{prop}$ ableitet. Das Ausgangssignal der Differenzierer-Einheit 43 gibt folglich Aufschluss über die Tendenz der Lampenanpassung, ob diese also sinkt oder steigt, und entspricht der zweiten Bedingung K2.

Die erste Bedingung K1 und die zweite Bedingung K2 werden einer Logikeinheit 45 zugeführt. Die Logikeinheit 45 ist mit einem Schieberegister, insbesondere mit einem 2-Bit-Schieberegister 47 verbunden, welches beispielsweise durch zwei D-Flip-Flops realisiert werden kann und erhält von diesen eine dritte Bedingung K3. Das Schieberegister 47 kann, wie in der Fig. 3 dargestellt, mit einem Taktgeber 49 verbunden sein, um den analogen Vorgang innerhalb des Amplitudendiskriminators 29 künstlich zu digitalisieren bzw. zu takten.

Eine mögliche Realisierung der Logikeinheit 45 des Amplitudendiskriminators 29 ist in der schematischen Ausführungsform gemäß Fig. 4 dargestellt. Die Logikeinheit 45 umfasst drei Eingänge 51, 53 und 55, wobei über den Eingang 51 die erste Bedingung K1, über den zweiten Eingang 53 die zweite Bedingung K2 und über den dritten Eingang 55 die dritte Bedingung K3 der Logikeinheit 45 zugeführt wird. Die Logikeinheit 45 umfasst ferner einen mit dem in Fig. 3 dargestellten Schieberegister 47 verbundenen Ausgang 57.

In der beispielhaften Ausführungsform gemäß Fig. 4 umfasst die Logikeinheit 45 zwei Logikgatter 59 und 61 sowie einen Inverter 63. Bei dem Logikgatter 61 handelt es sich beispielhaft um ein XOR-Gatter, während es sich bei dem Logikgatter 49 um ein AND-Gatter handelt. Im Inverter 63 wird das zugeführte Signal des XOR-Gatters 61 invertiert. Wenn am Ausgang 57 der Logikeinheit 45 das Ausgangssignal Y steht, gilt für die in Fig. 4 gezeigte Anordnung Folgendes:

$$Y = K1 \bullet \overline{(K2 \oplus K3)}$$

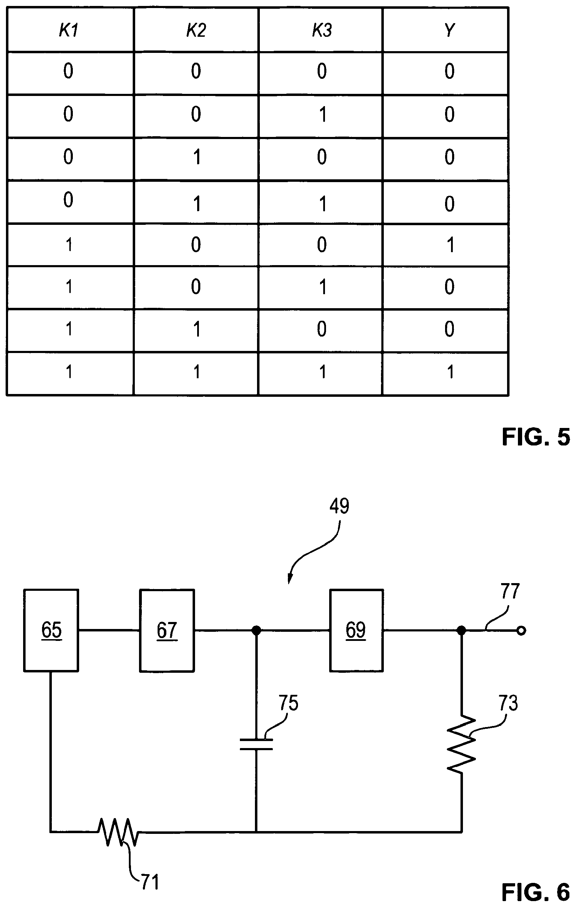

Die Logikeinheit 45, welche die oben genannte Beziehung aufweist, kann der in Fig. 5 gezeigten Wahrheitstabelle zugeordnet werden. Aus der Wahrheitstabelle gemäß Fig. 5 ergibt sich, dass bei dieser Ausführungsform die Ausgangsfrequenz des Oszillators 7 nur dann erhöht wird (Y=1), wenn die zur Lampenanpassung proportionale Spannung $U_{prop}$ vom Operationsverstärker 25 einen durch die Spannungswerterzeugungseinrichtung 41 festgelegten Wert überschreitet und gleichzeitig

- die durch die Differenzierer-Einheit 43 mit integriertem invertierendem Komparator erzeugte Bedingung K2 vorliegt (K2="1"), während das n-1 Bit aus dem Schieberegister 47 einer "1" entspricht

- oder die durch die Differenzierer-Einheit 43 mit integriertem invertiertem Komparator erzeugte Bedingung K2 nicht vorliegt (K2="0"), während das N-1 Bit aus dem Schieberegister 47 einer "0" entspricht.

Die Taktgebereinrichtung 49 ist von Vorteil, weil damit Fehlentscheidungen aufgrund eines Einschwingverhaltens der einzelnen Logikgatter vermieden werden können. Eine mögliche Realisierung der Taktgebereinrichtung 49 ist in der Fig. 6 dargestellt. Rein beispielhaft umfasst die Taktgebereinrichtung 49 dort drei Inverter 65, 67 und 69, zwei Widerstände 71 und 73 sowie einen Kondensator 75, um ein Signal am Ausgangsanschluss 77 mit einer festen Frequenz f zu realisieren. Für einen Widerstandswert R für die Widerstände 71 und 73 sowie einen Kapazitätswert C für den Kondensator 75 ergibt sich die folgende Frequenz:

$$f=0{,}558/(RC).$$

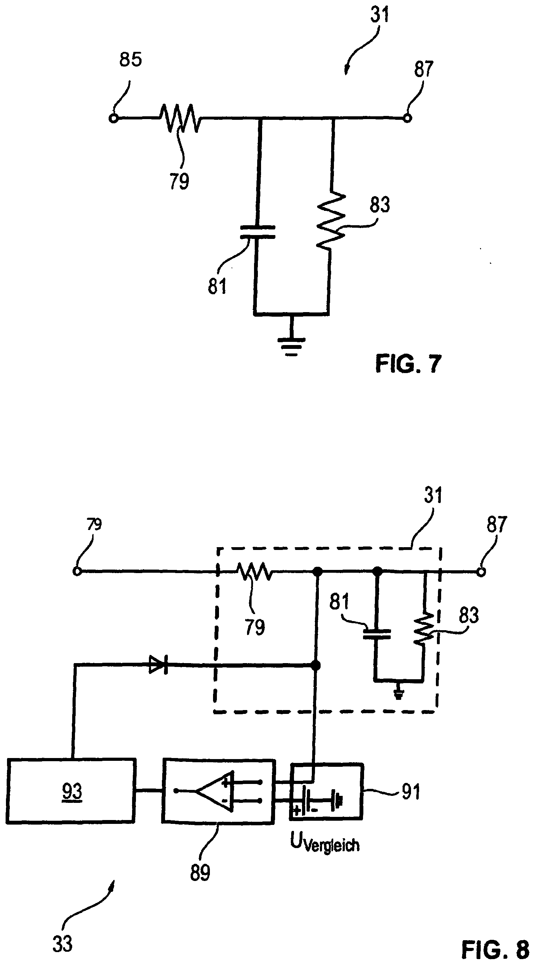

In Fig. 7 ist eine beispielhafte Ausführungsform des in Fig. 2 dargestellten Schleifenfilters 31 erkennbar, der eine getaktete Ausgangsspannung $U_D$ von dem Amplitudendiskriminator 29 erhält. Der Schleifenfilter 31 erzeugt aus den über das Schieberegister 47 laufenden digitalen Regelsignalen der Logikeinheit 45 eine analoge Spannung zur Regelung der Ausgangsfrequenz des Oszillators 7. In der Ausführungsform gemäß Fig. 7 umfasst der Schleifenfilter 31 einen Serienwiderstand 79 und mindestens einen Shunt-Kondensator 81 sowie mindestens einen Shunt-Widerstand 83, die sich zwischen den am Schieberegister 47 angeschlossenen Eingangsanschluss 85 und dem am Oszillator 7 angeschlossenen Ausgangsanschluss 87 des Schleifenfilters 31 befinden.

Zur Erhöhung der Ausgangsfrequenz des Oszillators 7 wird der Ausgang 57 der Logikeinheit 45 auf "1" gesetzt. Dieses Signal lädt den Shunt-Kondensator 81 im Schleifenfilter 31 über den Serienwiderstand 79 mit einer Zeitkonstante $\tau_{Lade}$, die dem Produkt des Widerstandswertes des Serienwiderstands 79 und der Kapazität des Shunt-Kondensators 81 entspricht, auf. Der Wert "0" am Ausgang 57 der Logikeinheit 45 führt dazu, dass die Ladung am Shunt-Kondensator 81 über die Parallelschaltung des Shunt-Widerstands 83 und des Widerstands 79 entladen wird. Die korrespondierende Zeitkonstante $\tau_{Entlade}$, entspricht dem Produkt der Kapazität des Shunt-Kondensators 81 und des resultierenden Widerstands der Parallelschaltung der zwei Widerstände 79 und 83.

Fig. 8 zeigt eine mögliche Ausführungsform der in Fig. 2 gezeigten Reset-Schaltung 33. Bei dieser Ausführungsform umfasst die Reset-Schaltung 33 einen Komparator 89, um die Spannung am Shunt-Kondensator 81 im Schleifenfilter 31 mit einer Referenzspannung $U_{Vergleich}$ zu vergleichen, wobei die Referenzspannung $U_{vergleich}$ beispielsweise durch einen externen Spannungsteiler 91 erzeugbar ist. Hierdurch kann die untere Grenzfrequenz der Regelung festgelegt werden. Wenn die Spannung am Shunt-Kondensator 81 im Schleifenfilter 31 den Spannungswert $U_{Vergleich}$ unterschreitet, wird über einen monostabilen Schalter 93 eine Spannung erzeugt, die den Shunt-Kondensator 81 im Schleifenfilter 31 auflädt. Hierdurch kann die Ausgangsfrequenz des Oszillators 7 auf eine obere Grenzfrequenz der Regelung festgelegt werden. Die Reset-Schaltung 33 und der daraus resultierende Reset-Vorgang können sowohl beim Einschalten als auch während des Betriebs der HF-Lampe 5 bei Bedarf aktiviert werden.

Zusammenfassend lässt sich festhalten, dass es sich bei dem in Fig. 2 gezeigten HF-System 1 lediglich um ein Ausführungsbeispiel handelt, welches in Bezug auf einige Elemente abänderbar ist. Insbesondere können die Auskoppeleinrichtungen durch einen Zirkulator ersetzt werden. Bei den Spannungserfassungseinrichtungen 21 und 23 kann es sich um beliebig ausgebildete geeignete Detektoren handeln. Ferner besteht die Möglichkeit, die in Fig. 8 gezeigte Reset-Schaltung 33 bzw. deren Funktion in die Logikeinheit 45 zu integrieren. Andererseits besteht die Möglichkeit, die Reset-Schaltung 33 durch Gatter, insbesondere durch Komparatoren und/oder einfache Sample-And-Hold-Schaltungen zu ersetzen.

Der Schleifenfilter 31 gemäß Fig. 7 kann im Übrigen durch Charge-Pumps, also Ladungspumpenschaltungen nach dem Vorbild einer Phase-Locked-Loop-Schaltung (PLL) ersetzt werden. Dabei kann die Schaltung so ausgebildet sein, dass eine optimale Betriebsfrequenz "gehalten" werden kann. In diesem Fall ist die Schaltung etwas komplexer und größer und erfordert eine neue Logikeinheit sowie negative Spannungen. Denkbar ist auch die Integration des Schleifenfilters 31 bzw. zumindest seine Funktion in die Logikeinheit 45. Eine analoge Ausgangsspannung wird dann unmittelbar in der Logikeinheit 45 erzeugt, sodass der Einsatz eines Taktgebers überflüssig ist. Denkbar ist auch die Erweiterung der Logikeinheit 45. Insbesondere können weitere Bedingungen berücksichtigt werden, die zusätzliche Funktionen ohne die Verwendung eines Mikroprozessors realisieren können. Hierzu sind dann evtl. zusätzliche Logik-Gatter notwendig. Im Übrigen kann auch das Schieberegister 47 geändert und insbesondere ergänzt werden, beispielsweise durch den Einsatz von astabilen Flip-Flops. Insbesondere können zusätzliche Elemente vorgesehen sein, welche den Taktgeber bzw. die Taktgebereinrichtung 49 überflüssig machen.

Auch die Verwendung von Verstärkern 9 und 12 sowie des Dämpfungsglieds 11 ist optional. Denkbar ist beispielsweise auch die Verwendung eines Verstärkers mit variabler Verstärkung zur exakteren Leistungseinstellung. Ebenso kann das Dämpfungsglied variabel ausgeführt sein oder ein entsprechendes zusätzliches variables Dämpfungsglied vorgesehen sein. Insbesondere ist auch die Reihenfolge der Verstärkung und der Dämpfung optional.

Insgesamt realisiert die vorliegende Erfindung ein HF-System und insbesondere eine vorteilhafte HF-Signaleinkopplungsvorrichtung zur Verwendung in einem HF-System zum möglichst verlustfreien Einkoppeln eines HF-Signals in eine HF-Einrichtung, insbesondere in eine HF-Lampe. Die HF-Signaleinkopplungs-vorrichtung ist vorzugsweise mikroprozessorlos ausgebildet und verwendet vielmehr Logik-Gatter, die einen Mikroprozessor überflüssig machen. Das HF-System realisiert auf diese Weise eine schnelle analoge Regelung der Ausgangsfrequenz einer HF-Signaleinkopplungsvorrichtung z.B. für Energiesparlampen. Die erfindungsgemäße HF-Signalkopplungsvorrichtung ermöglicht eine Zündung und einen effizienten Betrieb einer HF-Lampe bei derjenigen Betriebsfrequenz, welche die beste Anpassung an die HF-Lampe aufweist. Die vorteilhafte analoge Regelung kann weiterhin Frequenzverschiebungen kompensieren, die durch die Fertigungstoleranzen, das betriebsbedingte Temperaturverhalten oder alterungsbedingte Änderungen der der Elektronik hervorgerufen werden. Die implementierte Logikeinheit besteht aus einzelnen Logik-Gattern und ermöglicht folglich eine vorteilhafte Integration der Schaltung in einen einzigen Halbleiter-IC. Sie schafft folglich die Voraussetzungen für eine kostengünstige Realisierung der HF-Signaleinkopplungsvorrichtung und damit des gesamten HF-Systems in Massenherstellung.

Bezuaszeichenliste

| 1 | HF-System |
|---|---|
| 3 | HF-Signaleinkopplungsvorrichtung |
| 5 | HF-Einrichtung (HF-Lampe) |
| 7 | Oszillator |
| 9 | Verstärker |
| 11 | Dämpfungsglied |
| 13 | Verstärker |
| 15 | Mittel zur Erzeugung eines zum Anpassungsgrad der HF-Einrichung proportionalen Spannungsignals |
| 17 | Auskoppeleinrichtung |
| 19 | Auskoppeleinrichtung |
| 21 | Spannungserfassungseinrichtung |
| 23 | Spannungserfassungseinrichtung |
| 25 | Operationsverstärker |
| 27 | vorzugsweise mikroprozessorlose Einrichtung |

| 29 | Amplitudendiskriminator |
|----|----|
| 31 | Filtereinrichtung (Schleifenfilter) |
| 33 | Reset-Schaltung (Rücksetzeinrichtung) |
| 35 | Eingang |
| 37 | Vergleichseinrichtung |
| 39 | Komparator |
| 41 | Spannungswerterzeugungseinrichtung |
| 43 | Differenzierer-Einheit |
| 45 | Logikeinheit |
| 47 | Schieberegister |
| 49 | Taktgebereinrichtung |
| 51 | Eingang |
| 53 | Eingang |
| 55 | Eingang |
| 57 | Ausgang |
| 59 | Logik-Gatter |
| 61 | Logik-Gatter |
| 63 | Inverter |
| 65 | Inverter |
| 67 | Inverter |
| 69 | Inverter |
| 71 | Widerstand |
| 73 | Widerstand |
| 75 | Kondensator |
| 77 | Ausgangsanschluss |
| 79 | Serienwiderstand |
| 81 | Shunt-Kondensator |
| 83 | Shunt-Widerstand |
| 85 | Eingang |
| 87 | Ausgang |
| 89 | Komparator |
| 91 | externer Spannungsteiler |
| 93 | monostabiler Schalter |
| $f_0$ | Betriebsfrequenz |
| $f_0'$ | Verlagerte Betriebsfrequenz |
| a | Anteil des HF-Signals des Oszillators |
| b | Anteil des reflektierten Signals |
| $U_{prop}$ | zum Anpassungsgrad der Lampe proportionale Spannung |
| $U_D$ | getaktete Ausgangsspannung |
| $U_A$ | analoges Ausgangssignal |

**Patentansprüche**

1. Hochfrequenz-Signaleinkopplungsvorrichtung (3), eingerichtet zum Betrieb einer Hochfrequenz-Einrichtung (5), in Form einer Hochfrequenz-Lampe oder Hochfrequenz-Zündkerze, wobei die Hochfrequenz-Signaleinkopplungsvorrichtung aufweist:

   - einen Oszillator (7) zur Erzeugung eines Hochfrequenz-Signals das der Hochfrequenz-Einrichtung (5) zu ihrem Betrieb zugeführt wird;
   - Mittel (15), die zur Erzeugung eines zum Anpassungsgrad der Hochfrequenz-Einrichtung (5) proportionalen Spannungssignals ($U_{prop}$) auf der Grundlage des durch den Oszillator (7) erzeugten und der Hochfrequenzeinrichtung zugeführten Hochfrequenz-Signals und eines von der Hochfrequenz-Einrichtung reflektierten Signals eingerichtet sind; und
   - eine Einrichtung (27) zur Erzeugung eines Regelsignals ($U_A$) zur Anpassung der Ausgangsfrequenz des Oszillators (7) auf der Grundlage des zum Anpassungsgrad der Hochfrequenz-Einrichtung (5) proportionalen Spannungssignals ($U_{prop}$),

**dadurch gekennzeichnet, dass** die Einrichtung (27) eine

Filtereinrichtung (31) und einen Amplitudendiskriminator (29) aufweist, wobei der Amplitudendiskriminator (29) einen Komparator (39), eine Spannungswerterzeugungseinrichtung (41) und eine Logikeinheit (45) aufweist, wobei die Logikeinheit (45) mindestens ein Logikgatter (61, 63, 59) aufweist; wobei durch die Spannungswerterzeugungseinrichtung (41) ein fester Spannungswert erzeugt wird, wobei das zum Anpassungsgrad der Hochfrequenz-Einrichtung (5) proportionale Spannungssignal ($U_{prop}$) und der feste Spannungswert dem Komparator (39) zugeführt werden, wodurch das proportionale Spannungssignal ($U_{prop}$) und der feste Spannungswert verglichen werden und eine erste Bedingung (K1) erzeugt wird, wobei der Amplitudendiskriminator (29) dazu eingerichtet ist, auf der Grundlage des zum Anpassungsgrad der Hochfrequenz-Einrichtung (5) proportionalen Spannungssignals ($U_{prop}$) eine zweite Bedingung (K2) zu erzeugen, wobei die erste Bedingung (K1) und die zweite Bedingung (K2) dem mindestens einen Logikgatter (59, 61, 63) der Logikeinheit (45) zugeführt werden, wobei der Amplitudendiskriminator (29) weiter dazu ausgebildet ist, auf der Grundlage der ersten Bedingung (K1), der zweiten Bedingung (K2) und einer Wahrheitstabelle, auf der das mindestens eine Logikgatter (61, 63, 59) basiert, eine digitale oder getaktete Ausgangsspannung ($U_D$) zu erzeugen und an die Filtereinrichtung (31) auszugeben, wobei die Filtereinrichtung (31) dazu ausgebildet ist, die digitale oder getaktete Ausgangsspannung ($U_D$) derart zu glätten, dass ein analoges Ausgangssignal ($U_A$) erzeugt wird, welches dem Oszillator (7) als Regelsignal zur Anpassung der Ausgangsfrequenz ausgegeben wird.

2. Hochfrequenz-Signaleinkopplungsvorrichtung (3) nach Anspruch 1,
**dadurch gekennzeichnet, dass**
die Mittel zur Erzeugung eines zum Anpassungsgrad der Hochfrequenz-Einrichtung (5) proportionalen Spannungssignals ($U_{prop}$) mindestens eine Auskoppeleinrichtung (17, 19) zur Auskopplung eines Anteils des durch den Oszillator (7) erzeugten Hochfrequenz-Signals sowie zur Auskopplung eines Anteils des von der Hochfrequenz-Einrichtung (5) reflektierten Signals aufweisen.

3. Hochfrequenz-Signaleinkopplungsvorrichtung (3) nach Anspruch 1 oder 2,
**dadurch gekennzeichnet, dass**
die Mittel zur Erzeugung eines zum Anpassungsgrad der Hochfrequenz-Einrichtung (5) proportionalen Spannungssignals ($U_{prop}$) mindestens eine Spannungserfassungseinrichtung (21) zur Erfassung und Ausgabe eines Spannungssignals des ausgekoppelten Anteils des durch den Oszillator (7) erzeugten Hochfrequenz-Signals und mindestens eine weitere Spannungserfassungseinrichtung (23) zur Erfassung und Ausgabe eines Spannungssignals des ausgekoppelten Anteils des von der Hochfrequenz-Einrichtung (5) reflektierten Signals aufweisen.

4. Hochfrequenz-Signaleinkopplungsvorrichtung (3) nach einem der vorhergehenden Ansprüche,
**dadurch gekennzeichnet, dass**
die Mittel zur Erzeugung eines zum Anpassungsgrad der Hochfrequenz-Einrichtung (5) proportionalen Spannungssignals ($U_{prop}$) mindestens eine Einrichtung aufweist, welche auf der Grundlage des Spannungssignals des ausgekoppelten Anteils des von der Hochfrequenz-Einrichtung (5) reflektierten Signals sowie des Spannungssignals des ausgekoppelten Anteils des durch den Oszillator (7) erzeugten Hochfrequenz-Signals, ein zum Anpassungsgrad der Hochfrequenz-Einrichtung (5) proportionales Spannungssignal ($U_{prop}$) erzeugt.

5. Hochfrequenz-Signaleinkopplungsvorrichtung (3) nach Anspruch 1,
**dadurch gekennzeichnet, dass**
die Mittel zur Erzeugung eines zum Anpassungsgrad der Hochfrequenz-Einrichtung (5) proportionalen Spannungssignals ($U_{prop}$) einen Zirkulator aufweisen, der zur Auskopplung eines Anteils des durch den Oszillator (7) erzeugten Hochfrequenz-Signals sowie zur Auskopplung eines Anteils des von der Hochfrequenz-Einrichtung (5) reflektierten Signals ausgebildet ist.

6. Hochfrequenz-Signaleinkopplungsvorrichtung (3) nach Anspruch 5,
**dadurch gekennzeichnet, dass**
der Zirkulator mindestens eine Einrichtung aufweist, insbesondere mindestens einen Operationsverstärker oder mindestens eine Verstärkerschaltung, welche auf der Grundlage der Spannungssignale der ausgekoppelten Anteile ein zum Anpassungsgrad der Hochfrequenz-Einrichtung (5) proportionales Spannungssignal erzeugt.

7. Hochfrequenz-Signaleinkopplungsvorrichtung (3) nach Anspruch 1,
**dadurch gekennzeichnet, dass**
ein Schieberegister (47) zum Empfang eines Ausgangssignals (Y) der Logikeinheit (45) vorgesehen ist.

8. Hochfrequenz-Signaleinkopplungsvorrichtung (3) nach Anspruch 7,
**dadurch gekennzeichnet, dass**
eine Taktgebereinrichtung (49) zur Taktung des Ausgangssignals (Y) der Logikeinheit (45) vorgesehen ist.

9. Hochfrequenz-Signaleinkopplungsvorrichtung (3) nach einem der Ansprüche 1, 7 oder 8,
**dadurch gekennzeichnet, dass**
die Logikeinheit (45) über die Filtereinrichtung (31) zur Erzeugung der analogen Ausgangsspannung ($U_A$), zur Regelung der Frequenz des Oszillators (7) mit diesem verbunden ist.

10. Hochfrequenz-Signaleinkopplungsvorrichtung (3) nach Anspruch 9,
**dadurch gekennzeichnet, dass**
die Filtereinrichtung (31) zur Erzeugung des analogen Ausgangssignals ($U_A$) zur Regelung der Frequenz des Oszillators (7) ein Schleifenfilter oder eine Ladungspumpenanordnung sein kann.

11. Hochfrequenz-Signaleinkopplungsvorrichtung (3) nach einem der Ansprüche 1, 7 oder 8,
**dadurch gekennzeichnet, dass**
die Einrichtung (27), insbesondere die Logikeinheit (45), so ausgebildet ist, dass sie zur Erzeugung des analogen Ausgangssignals ($U_A$) zur Regelung der Frequenz des Oszillators (7) ausgebildet ist.

12. Hochfrequenz-Signaleinkopplungsvorrichtung (3) nach einem der vorhergehenden Ansprüche,
**dadurch gekennzeichnet, dass**
eine Reset-Schaltung (33) vorgesehen ist, die zum Versetzen des Oszillators (7) in einen vordefinierten Zustand ausgebildet ist.

13. Hochfrequenz-System (1) aufweisend eine Hochfrequenz-Signaleinkopplungsvorrichtung (3) nach einem der Ansprüche 1-12 und eine Hochfrequenz-Einrichtung (5), in Form einer Hochfrequenz-Lampe oder Hochfrequenz-Zündkerze.

**14.** Verfahren zum Betrieb eines Hochfrequenz-Systems (1) nach Anspruch 13, umfassend die Schritte:

Erzeugen eines festen Spannungswerts in der Spannungswerterzeugungseinrichtung (41) des Amplitudendiskriminators (29),
Erzeugen einer ersten Bedingung (K1), durch das dem Komparator (39) Zuführen des zum Anpassungsgrad der Hochfrequenz-Einrichtung (5) proportionalen Spannungssignal ($U_{prop}$) und des festen Spannungswerts und dem Vergleichen des proportionalen Spannungssignals ($U_{prop}$) und des festen Spannungswerts im Komparator (39),
Erzeugen einer zweiten Bedingung (K2) im Amplitudendiskriminator (29), auf der Grundlage des zum Anpassungsgrad der Hochfrequenz-Einrichtung (5) proportionalen Spannungssignals ($U_{prop}$),
Zuführen der ersten Bedingung (K1) und der zweiten Bedingung (K2), dem mindestens einen Logikgatter (59, 61, 63) der Logikeinheit (45),
Erzeugen einer digitalen oder getakteten Ausgangsspannung ($U_D$) im Amplitudendiskriminator (29), auf der Grundlage der ersten Bedingung (K1), der zweiten Bedingung (K2) und einer Wahrheitstabelle, auf der das mindestens eine Logikgatter (61, 63, 59) basiert, und
Ausgeben der digitalen oder getakteten Ausgangsspannung ($U_D$) an die Filtereinrichtung (31),
Erzeugen eines analogen Ausgangssignals ($U_A$) durch Glätten der digitalen oder getakteten Ausgangsspannung ($U_D$) durch die Filtereinrichtung (31),
Ausgeben des analogen Ausgangssignals ($U_A$) an den Oszillator (7) als Regelsignal zur Anpassung der Ausgangsfrequenz des Oszillators.

**15.** Verfahren nach Anspruch 14,
**dadurch gekennzeichnet, dass**
die zweiten Bedingung (K2) durch Ableiten des zum Anpassungsgrad der Hochfrequenz-Einrichtung (5) proportionalen Spannungssignals ($U_{prop}$) erhalten wird.

**Claims**

**1.** High-frequency signal injection device (3), adapted to operate a high-frequency device (5), in the form of a high-frequency lamp or high-frequency spark plug, wherein the high-frequency signal injection device comprises:

- an oscillator (7) for generating a high-frequency signal which is supplied to the high-frequency device (5) for its operation;

- means (15) adapted to generate a voltage signal ($U_{prop}$) proportional to the degree of adaptation of the high-frequency device (5) on the basis of the high-frequency signal generated by the oscillator (7) and supplied to the high-frequency device and a signal reflected from the high-frequency device; and
- a device (27) for generating a regulating signal ($U_A$) for adjusting the output frequency of the oscillator (7) based on the voltage signal ($U_{prop}$) proportional to the degree of adaptation of the high-frequency device (5),

**characterized in that** the device (27) comprises a filter device (31) and an amplitude discriminator (29),

wherein the amplitude discriminator (29) comprises a comparator (39), a voltage value generating device (41) and a logic unit (45), wherein the logic unit (45) comprises at least one logic gate (61, 63, 59);
wherein a fixed voltage value is generated by the voltage value generating device (41),
wherein the voltage signal ($U_{prop}$) proportional to the degree of adaptation of the high-frequency device (5) and the fixed voltage value are supplied to the comparator (39), whereby the proportional voltage signal ($U_{prop}$) and the fixed voltage value are compared and a first condition (K1) is generated,
wherein the amplitude discriminator (29) is adapted to generate a second condition (K2) based on the voltage signal ($U_{prop}$) proportional to the degree of adaptation of the high-frequency device (5),
wherein the first condition (K1) and the second condition (K2) are supplied to the at least one logic gate (59, 61, 63) of the logic unit (45),
wherein the amplitude discriminator (29) is further adapted to generate and output a digital or clocked output voltage ($U_D$) to the filter device (31) based on the first condition (K1), the second condition (K2) and a truth table on which the at least one logic gate (61, 63, 59) is based,
wherein the filter device (31) is designed to smooth the digital or clocked output voltage ($U_D$) in such a way that an analog output signal ($U_A$) is generated which is output to the oscillator (7) as a regulating signal for adjusting the output frequency.

**2.** High-frequency signal injection device (3) according to claim 1, **characterized in that** the means for generating a voltage signal ($U_{prop}$) proportional to the degree of adaptation of the high-frequency device (5) comprise at least one decoupling device (17, 19) for coupling out a portion of the high-frequency signal generated by the oscillator (7) and for coupling out a portion of the signal reflected by the high-frequency device (5).

3. High-frequency signal injection device (3) according to claim 1 or 2, **characterized in that** the means for generating a voltage signal ($U_{prop}$) proportional to the degree of adaptation of the high-frequency device (5) comprise at least one voltage detection device (21) for detecting and outputting a voltage signal of the coupled-out portion of the high-frequency signal generated by the oscillator (7) and at least one further voltage detection device (23) for detecting and outputting a voltage signal of the coupled-out portion of the signal reflected by the high-frequency device (5).

4. High-frequency signal injection device (3) according to one of the preceding claims, **characterized in that** the means for generating a voltage signal ($U_{prop}$) proportional to the degree of adaptation of the high-frequency device (5) comprises at least one device which generates a voltage signal ($U_{prop}$) proportional to the degree of adaptation of the high-frequency device (5) on the basis of the voltage signal of the coupled-out portion of the signal reflected by the high-frequency device (5) and the voltage signal of the coupled-out portion of the high-frequency signal generated by the oscillator (7).

5. High-frequency signal injection device (3) according to claim 1, **characterized in that** the means for generating a voltage signal ($U_{prop}$) proportional to the degree of adaptation of the high-frequency device (5) comprise a circulator designed to couple out a portion of the high-frequency signal generated by the oscillator (7) and to couple out a portion of the signal reflected by the high-frequency device (5).

6. High-frequency signal injection device (3) according to claim 5, **characterized in that** the circulator comprises at least one device, in particular at least one operational amplifier or at least one amplifier circuit, which generates a voltage signal proportional to the degree of adaptation of the high-frequency device (5) on the basis of the voltage signals of the coupled-out portions.

7. High-frequency signal injection device (3) according to claim 1, **characterized in that** a shift register (47) is provided for receiving an output signal (Y) of the logic unit (45).

8. High-frequency signal injection device (3) according to claim 7, **characterized in that** a clock generator device (49) is provided for clocking the output signal (Y) of the logic unit (45).

9. High-frequency signal injection device (3) according to one of claims 1, 7 or 8, **characterized in that** the logic unit (45) is connected to the oscillator (7) via the filter device (31) for generating the analog output voltage ($U_A$), for regulating the frequency of the oscillator (7).

10. High-frequency signal injection device (3) according to claim 9, **characterized in that** the filter device (31) for generating the analog output signal ($U_A$) for regulating the frequency of the oscillator (7) may be a loop filter or a charge pump arrangement.

11. High-frequency signal injection device (3) according to one of claims 1, 7 or 8, **characterized in that** the device (27), in particular the logic unit (45), is designed to generate the analog output signal ($U_A$) for regulating the frequency of the oscillator (7).

12. High-frequency signal injection device (3) according to one of the preceding claims, **characterized in that** a reset circuit (33) is provided, which is designed to set the oscillator (7) to a predefined state.

13. High-frequency system (1) comprising a high-frequency signal injection device (3) according to one of claims 1 to 12 and a high-frequency device (5), in the form of a high-frequency lamp or high-frequency spark plug.

14. Method for operating a radio frequency system (1) according to claim 13, comprising the steps of:

generating a fixed voltage value in the voltage value generating device (41) of the amplitude discriminator (29),
generating a first condition (K1) by supplying to the comparator (39) the voltage signal ($U_{prop}$) proportional to the degree of adaptation of the high-frequency device (5) and the fixed voltage value, and comparing the proportional voltage signal ($U_{prop}$) and the fixed voltage value in the comparator (39),
generating a second condition (K2) in the amplitude discriminator (29), based on the voltage signal ($U_{prop}$) proportional to the degree of adaptation of the high-frequency device (5),
supplying the first condition (K1) and the second condition (K2), to the at least one logic gate (59, 61, 63) of the logic unit (45),
generating a digital or clocked output voltage ($U_D$) in the amplitude discriminator (29), based on the first condition (K1), the second condition (K2) and a truth table on which the at least one logic gate (61, 63, 59) is based, and
outputting the digital or clocked output voltage ($U_D$) to the filter device (31),
generating an analog output signal ($U_A$) by smoothing the digital or clocked output voltage ($U_D$) by the filter device (31),

outputting the analog output signal ($U_A$) to the oscillator (7) as a regulating signal for adjusting the output frequency of the oscillator.

15. Method according to claim 14, **characterized in that** the second condition (K2) is obtained by deriving the voltage signal ($U_{prop}$) proportional to the degree of adaptation of the high-frequency device (5).


**Revendications**

1. Dispositif de couplage de signaux radiofréquence (3) agencé pour faire fonctionner un dispositif radiofréquence (5), sous la forme d'une lampe radiofréquence ou d'une bougie d'allumage radiofréquence, le dispositif de couplage de signaux radiofréquence présentant

- un oscillateur (7) pour générer un signal radiofréquence qui est appliqué au dispositif radiofréquence (5) pour son fonctionnement;
- des moyens (15) agencés pour générer un signal de tension ($U_{prop}$) proportionnel au degré d'adaptation du dispositif radiofréquence (5) sur la base du signal radiofréquence généré par l'oscillateur (7) et appliqué au dispositif radiofréquence et d'un signal réfléchi par le dispositif radiofréquence; et
- un dispositif (27) pour générer un signal de régulation ($U_A$) pour adapter la fréquence de sortie de l'oscillateur (7) sur la base du signal de tension ($U_{prop}$) proportionnel au degré d'adaptation du dispositif radiofréquence (5),

**caractérisé en ce que** le dispositif (27) présente un dispositif de filtrage (31) et un discriminateur d'amplitude (29),

dans lequel le discriminateur d'amplitude (29) présente un comparateur (39), un dispositif de génération de valeur de tension (41) et une unité logique (45), l'unité logique (45) présentant au moins une porte logique (61, 63, 59) ;

dans lequel une valeur de tension fixe est générée par ledit moyen de génération de valeur de tension (41),

dans lequel le signal de tension ($U_{prop}$) proportionnel au degré d'adaptation du dispositif radiofréquence (5) et la valeur de tension fixe sont appliqués au comparateur (39), comparant ainsi le signal de tension ($U_{prop}$) proportionnel et la valeur de tension fixe et générant une première condition (K1),

dans lequel le discriminateur d'amplitude (29) est agencé pour générer une deuxième condition (K2) sur la base du signal de tension ($U_{prop}$) proportionnel au degré d'adaptation du dispositif radiofréquence (5),

dans lequel la première condition (K1) et la deuxième condition (K2) sont appliquées à l'au moins une porte logique (59, 61, 63) de l'unité logique (45),

dans lequel le discriminateur d'amplitude (29) est en outre conçu pour générer et émettre en sortie une tension de sortie numérique ou synchronisée ($U_D$) au dispositif de filtrage (31) sur la base de la première condition (K1), de la deuxième condition (K2) et d'une table de vérité sur laquelle l'au moins une porte logique (61, 63, 59) est basée,

le dispositif de filtrage (31) étant conçu pour lisser la tension de sortie numérique ou synchronisée ($U_D$) de manière à générer un signal de sortie analogique ($U_A$) qui est émis à l'oscillateur (7) en tant que signal de régulation pour adapter la fréquence de sortie.

2. Dispositif de couplage de signaux radiofréquence (3) selon la revendication 1, **caractérisé en ce que** les moyens pour générer un signal de tension ($U_{prop}$) proportionnel au degré d'adaptation du dispositif radiofréquence (5) présentent au moins un dispositif de découplage (17, 19) pour découpler une partie du signal radiofréquence généré par l'oscillateur (7) ainsi que pour découpler une partie du signal réfléchi par le dispositif radiofréquence (5).

3. Dispositif de couplage de signaux radiofréquence (3) selon la revendication 1 ou 2, **caractérisé en ce que** les moyens pour générer un signal de tension ($U_{prop}$) proportionnel au degré d'adaptation du dispositif radiofréquence (5) présentent au moins un dispositif de détection de tension (21) pour détecter et émettre un signal de tension de la partie découplée du signal radiofréquence généré par l'oscillateur (7) et au moins un autre dispositif de détection de tension (23) pour détecter et émettre un signal de tension de la partie découplée du signal réfléchi par le dispositif radiofréquence (5).

4. Dispositif de couplage de signaux radiofréquence (3) selon l'une des revendications précédentes, **caractérisé en ce que** les moyens pour générer un signal de tension ($U_{prop}$) proportionnel au degré d'adaptation du dispositif radiofréquence (5) présentent au moins un dispositif qui génère un signal de tension ($U_{prop}$) proportionnel au degré d'adaptation du dispositif radiofréquence (5) sur la base du signal de tension de la partie découplée du signal réfléchi par le dispositif radiofréquence (5) et du signal de tension de la partie découplée du signal radiofréquence généré par l'oscillateur (7).

**5.** Dispositif de couplage de signaux radiofréquence (3) selon la revendication 1, **caractérisé en ce que** les moyens pour générer un signal de tension (U_{prop}) proportionnel au degré d'adaptation du dispositif radiofréquence (5) présentent un circulateur qui est conçu pour découpler une partie du signal radiofréquence généré par l'oscillateur (7) ainsi que pour découpler une partie du signal réfléchi par le dispositif radiofréquence (5).

**6.** Dispositif de couplage de signaux radiofréquence (3) selon la revendication 5, **caractérisé en ce que** le circulateur présente au moins un dispositif, en particulier au moins un amplificateur opérationnel ou au moins un circuit amplificateur qui génère, sur la base des signaux de tension des parties découplées, un signal de tension proportionnel au degré d'adaptation du dispositif radiofréquence (5).

**7.** Dispositif de couplage de signaux radiofréquence (3) selon la revendication 1, **caractérisé en ce qu'**un registre à décalage (47) est prévu pour recevoir un signal de sortie (Y) de l'unité logique (45).

**8.** Dispositif de couplage de signaux radiofréquence (3) selon la revendication 7, **caractérisé en ce qu'**un dispositif d'horloge (49) est prévu pour l'horloge du signal de sortie (Y) de l'unité logique (45).

**9.** Dispositif de couplage de signaux radiofréquence (3) selon l'une des revendications 1, 7 ou 8, **caractérisé en ce que** l'unité logique (45) est reliée à l'oscillateur (7) par l'intermédiaire du dispositif de filtrage (31) pour générer la tension de sortie analogique (U_A), pour réguler la fréquence de l'oscillateur (7).

**10.** Dispositif de couplage de signaux radiofréquence (3) selon la revendication 9, **caractérisé en ce que** le dispositif de filtrage (31) pour générer le signal de sortie analogique (U_A), pour réguler la fréquence de l'oscillateur (7) peut être un filtre à boucle ou un ensemble de pompe de charge.

**11.** Dispositif de couplage de signaux radiofréquence (3) selon l'une des revendications 1, 7 ou 8, **caractérisé en ce que** le dispositif (27), en particulier l'unité logique (45), est conçu de manière à être conçu pour générer le signal de sortie analogique (U_A) pour réguler la fréquence de l'oscillateur (7).

**12.** Dispositif de couplage de signaux radiofréquence (3) selon l'une des revendications précédentes, **caractérisé en ce qu'**il est prévu un circuit de réinitialisation (33) qui est conçu pour mettre l'oscillateur (7) dans un état prédéfini.

**13.** Système radiofréquence (1) présentant un dispositif de couplage de signaux radiofréquence (3) selon l'une des revendications 1 à 12 et un dispositif radiofréquence (5), sous la forme d'une lampe radiofréquence ou d'une bougie d'allumage radiofréquence.

**14.** Procédé d'exploitation d'un système radiofréquence (1) selon la revendication 13, comprenant les étapes suivantes :

Génération d'une valeur de tension fixe dans le dispositif de génération de valeur de tension (41) du discriminateur d'amplitude (29),
Génération d'une première condition (KI) en appliquant au comparateur (39) le signal de tension (U_{prop}) proportionnel au degré d'adaptation du dispositif radiofréquence (5) et la valeur de tension fixe, et comparant le signal de tension (U_{prop}) proportionnel et la valeur de tension fixe dans le comparateur (39),
Génération d'une deuxième condition (K2) dans le discriminateur d'amplitude (29) sur la base du signal de tension (U_{prop}) proportionnel au degré d'adaptation du dispositif radiofréquence (5),
Application de la première condition (K1) et de la deuxième condition (K2) à l'au moins une porte logique (59, 61, 63) de l'unité logique (45),
Génération d'une tension de sortie numérique ou synchronisée (U_D) dans le discriminateur d'amplitude (29) sur la base de la première condition (K1), de la deuxième condition (K2) et d'une table de vérité sur laquelle l'au moins une porte logique (61, 63, 59) est basée, et
Émission de la tension de sortie numérique ou synchronisée (U_D) au dispositif de filtrage (31),
Génération d'un signal de sortie analogique (U_A) en lissant la tension de sortie numérique ou synchronisée (U_D) à travers le dispositif de filtrage (31),
Émission du signal de sortie analogique (U_A) à l'oscillateur (7) en tant que signal de régulation pour adapter la fréquence de sortie de l'oscillateur.

**15.** Procédé selon la revendication 14, **caractérisé en ce que** la deuxième condition (K2) est obtenue en dérivant le signal de tension (U_{prop}) proportionnel au degré d'adaptation du dispositif radiofréquence (5).

**FIG. 1a**

**FIG. 1b**

**FIG. 2**

**FIG. 3**

**FIG. 4**

| K1 | K2 | K3 | Y |
|---|---|---|---|
| 0 | 0 | 0 | 0 |
| 0 | 0 | 1 | 0 |
| 0 | 1 | 0 | 0 |
| 0 | 1 | 1 | 0 |
| 1 | 0 | 0 | 1 |
| 1 | 0 | 1 | 0 |
| 1 | 1 | 0 | 0 |
| 1 | 1 | 1 | 1 |

**FIG. 5**

**FIG. 6**

FIG. 7

$U_{Vergleich}$

FIG. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2009068618 A2
- US 2002079845 A1
- US 20100253231 A1
- US 20100283389 A1